# EUROPEAN PATENT APPLICATION

(11) **EP 2 597 690 A2**
(43) Date of publication of application: **29.05.2013**
(21) Application number: 12194615.6
(22) Date of filing: 28.11.2012
(51) Int. Cl.: H01L 33/54

(54) **Led package**

(30) Priority: 28.11.2011 TW 100143498
(71) Applicant: Lextar Electronics Corp., 30075 Hsinchu (TW)
(72) Inventor: Lin, Yu-Min, 220 New Taipei City (TW); Liao, Cheng-Chun, 300 Hsinchu City (TW); Cheng, Chia-Shen, 401 Taichung City (TW)
(74) Representative: von Kreisler Selting Werner

(57) **Abstract**

An LED package is provided, which includes a base, a lighting device, and a sealing material. The lighting device is disposed on the base. The sealing material is disposed on the lighting material, and the out surface of the sealing material includes a plurality of micro-structures. The micro-structures comprise of protruded micro-structures, depressed micro-structures or any combination thereof. At least of a partial of a light from the lighting element is transmitted to an ambient through the micro-structure.

## Description

### Field of the Invention

The present invention relates to an LED package, and in particular relates to an LED package, in which the outer surface of the sealing material has micro structures.

### Description of the Related Art

Light emitting diode (LED), having the advantages of low power consumption, low driving voltage, long lifespan, and environmental friendliness, has been widely used in various lighting devices and the backlight module of liquid crystal display (LCD). The LED package protects the chip from being damaged by external moisture, oxygen, radiation or external force.

The refraction index of the sealing material used in a conventional LED package is about 1.5, and the total reflection angle between the sealing material and the air is about 42 degrees. If the light emitting surface of the sealing material is a planar structure, the light will be totally reflected in the sealing material. Consequently, problems such as decreased extraction efficiency of the light, deteriorated element efficiency, and the turning yellow packaging material will occur.

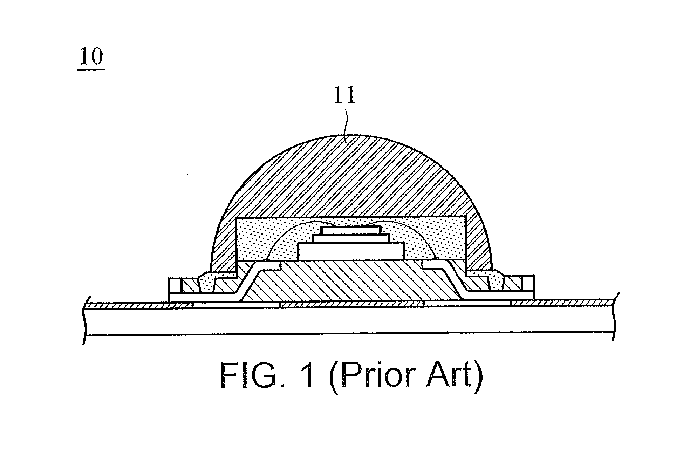

According to the United State Patent No. 7, 875, 476, the sealing material molding technology is used for curing the sealing material 11 into a semi-sphere as indicated in FIG. 1 to reduce the likelihood of the light being totally reflected in the sealing material 11 and increase the extraction efficiency. However, the above method cannot be used in any package 10 that is not circular or squared. The process of curing the sealing material 11 into a sphere requires a large amount of material, and the cost will further increased if the curing process is used in a large-scaled package 10.

### BRIEF SUMMARY OF THE INVENTION

It is therefore an object of the invention to provide a light emitting diode (LED) package which has extraction efficiency but is easy to manufacture.

To achieve the above object, the invention provides an LED package, comprising a base, a lighting device and a sealing material. The lighting device is disposed on the base. The sealing material is disposed on the lighting device. The outer surface of the sealing material comprises a plurality of the micro-structures. The micro-structures are composed of a plurality of depressed micro-structures, a plurality of protruded micro-structures or any combination thereof. At least a partial of a light emitted from the lighting device is transmitted to an ambient environment through the micro-structures.

In the exemplary embodiment disclosed above, the protruded micro-structures and depressed micro-structures have a pyramid shape. The pyramid shape has four sides with an apex angle of 70 degrees and a height of 0.5 mm.

In the exemplary embodiment disclosed above, each of the protruded micro-structures is a micro-particle whose refraction index is approximately equal to that of the sealing material. The micro-particle has a spherical shape, an elliptical shape, a polygonal shape or any combination thereof. The micro-particles are spaced apart from each other by a distance ranging between 0 and 500 µm, the diameter of micro-particles ranges between 10 and 500 µm, and the surface roughness (Ra) of the sealing material is about 30 µm.

In the exemplary embodiment disclosed above, the base comprises an accommodating space defined in a side wall. The lighting device is disposed in the accommodating space. The sealing material is filled in the accommodating space to cover the lighting device. The depressed micro-structures are depressed from a reference surface in a direction towards the lighting device, and the protruded micro-structures are protruded from the reference surface in a direction away from the lighting device. The reference surface is a plane, which is aligned with the outer rim of the side wall.

In the exemplary embodiment disclosed above, each of the protruded micro-structures is a micro particle whose refraction index is equal to the refraction index of the sealing material, and a portion of each of the micro particles is located below the reference surface. The ratio of the volume of the protruded portion of the micro particle above the reference surface to the volume of the entire micro particle is about 33-66%.

In the exemplary embodiment disclosed above, the micro-structures are spaced apart from each other by a distance ranging between 0 and 500 µm.

With the micro-structures being disposed on the surface of the sealing material, the likelihood of total reflection of the light in the sealing material is reduced and the utilization of the light is increased.

### BRIEF DESCRIPTION OF THE DRAWINGS

The present invention is more fully understood by reading the subsequent detailed description and examples with references made to the accompanying drawings, wherein:

FIG. 1 shows a cross-sectional view of a package according to generally known technology;

FIG. 2 shows an LED package according to an exemplary embodiment of the invention;

FIG. 3 shows a cross-sectional view of an LED package according to an exemplary embodiment of the invention;

FIG. 4 shows an enlargement view of an area A of FIG. 3;

FIG. 5 shows a top view of a partial structure of an area A of FIG. 3;

FIG. 6 shows a process for manufacturing an LED package according to an exemplary embodiment of the invention;

FIG. 7 shows a cross-sectional view of an LED package according to another embodiment of the invention;

FIG. 8 shows an enlargement view of an area B of FIG. 7;

FIG. 9 shows a cross-sectional view of an LED package according to another embodiment of the invention;

FIG. 10 shows an enlargement view of an area C of FIG. 9;

FIG. 11A shows a top view of an area C of FIG. 9;

FIG. 11B shows an appearance of the micro-structures of FIG. 11 A;

FIG. 12 shows a cross-sectional view of an LED package according to another embodiment of the invention;

FIG. 13A shows a top view of an area D of FIG. 12;

FIG. 13B shows an appearance of the micro-structures of FIG. 13A and

FIG. 14 shows a cross-sectional view of an LED package according to another embodiment of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

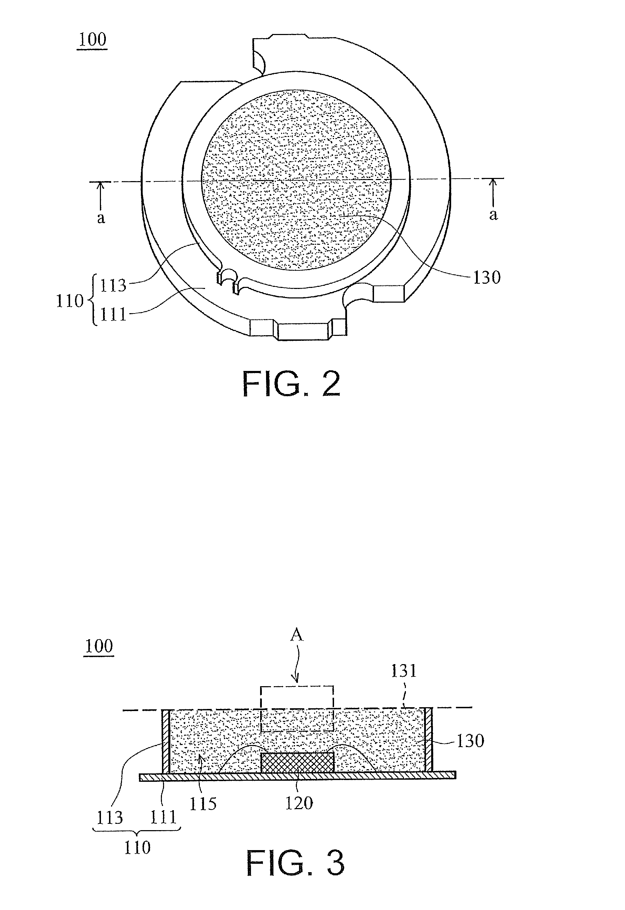

Referring to FIGS. 2 and 3, wherein FIG. 3 shows a cross-sectional view of an LED package viewed along a segment a-a of FIG. 2 according to an exemplary embodiment of the invention. The LED package 100 according to an exemplary embodiment of the invention comprises a base 110, a lighting device 120 and a sealing material 130. The base 110 comprises a bottom plate 111 and a side wall 113. The side wall 113 is protruded from the bottom plate 111, and an accommodating space 115 is defined in the side wall 113.

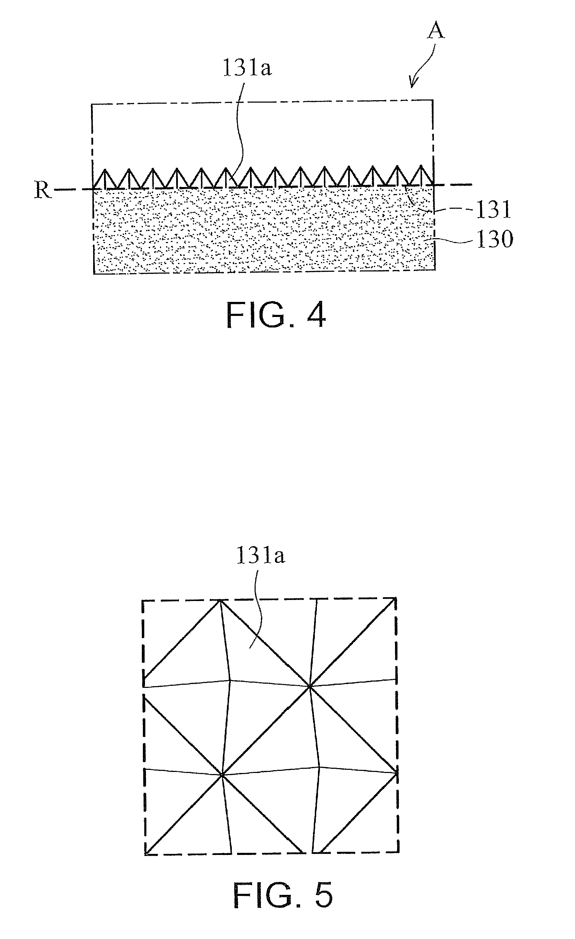

Referring to FIGS. 3 to 5, wherein FIG. 4 shows an enlargement view of an area A of FIG. 3. FIG. 5 shows a top view of a partial structure of an area A of FIG. 3. The sealing material 130 is filled in the accommodating space 115 to cover the lighting device 120. The outer surface 131 of the sealing material 130 comprises a plurality of micro-structures 131 a protruded from a reference surface R in a direction towards the lighting device 120. The reference surface R is aligned with an outer rim of the side wall 113, but the invention is not limited thereto. The micro-structures 131 a have a pyramid shape and are spaced apart from each other by a distance ranging between 0 and 500 µm.

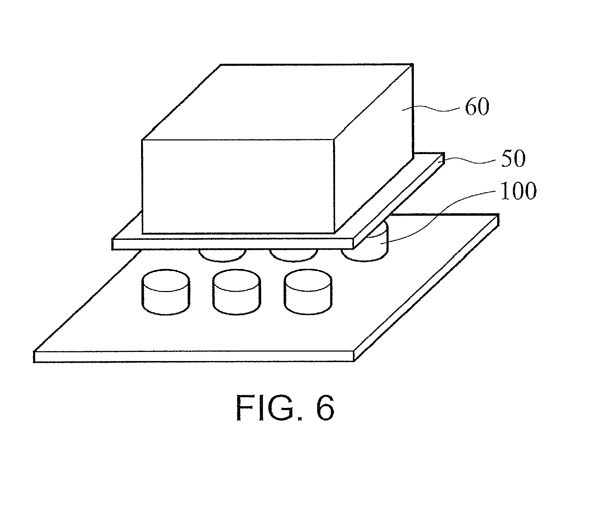

A method for manufacturing an LED package 100 according to an exemplary embodiment of the invention is disclosed below. Referring to FIG. 6. Firstly, a Teflon sheet 50 is provided, and the surface of the Teflon sheet 50 is cut to form a plurality of patterns complementary with the micro-structures 131 a (FIG. 4), so that the surface of the Teflon sheet 50 has a roughness structure. Next, a heavy object 60 is used to press the Teflon sheet 50 on the surface of the sealing material 130 of the LED package 100, wherein the sealing material is imprinted by the roughness structure of the Teflon sheet before the sealing material is completely cured. Then, the sealing material 130 (FIG. 4) of the LED package 100 is dried by baking to finish the molding of the micro-structures 131.

Wherein, the sealing material 130 is mainly formed by transparent epoxy resin or silicone.

When the lighting device 120 operates, at least a partial of a light emitted from the lighting device 120 is transmitted to an ambient environment through the micro-structures 131 a. Therefore, the likelihood of total reflection of the light in the sealing material 130 is reduced, the extraction efficiency of the lighting device 120 is increased, and the packaging material 130 turning yellow earlier than expected is avoided. Experimental data show that the sealing material 130 with micro-structures 131 a increases extraction efficiency by 13.68%.

The micro-structures 131 a of the invention are not limited to the above implementations. Various implementations of the micro-structures 131 a are exemplified below.

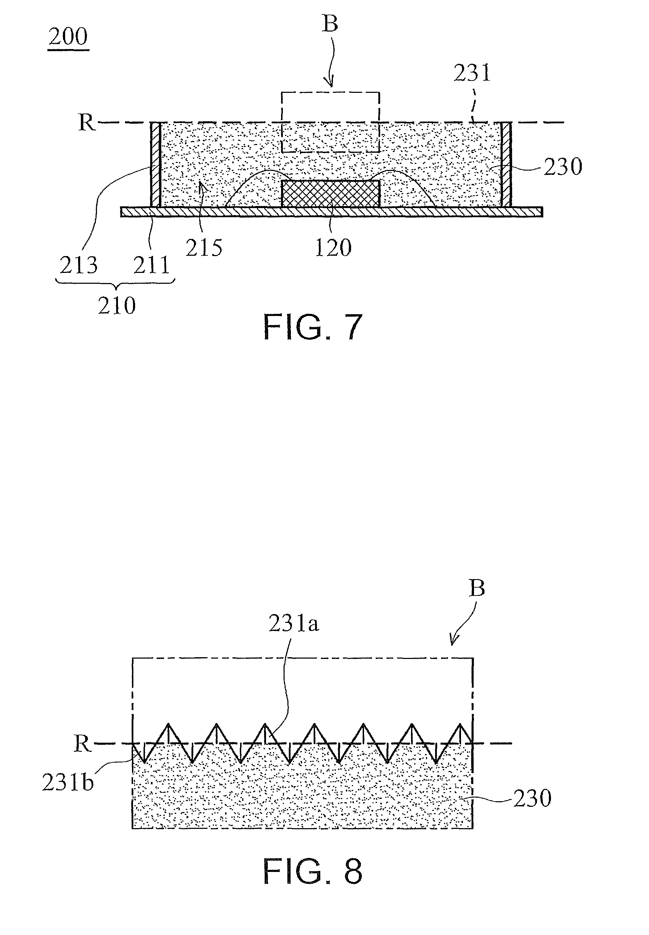

Referring to FIGS. 7 and 8, wherein FIG. 7 shows a cross-sectional view of an LED package 200 according to another embodiment of the invention, and FIG. 8 shows an enlargement view of an area B of FIG. 7. In the present embodiment, corresponding components similar or identical to above embodiments retain the same numeric designations, and the similarities of corresponding components that have been disclosed are not repeated. The LED package 200 is different from the LED package 100 in that: the sealing material 230 comprises a plurality of micro-structures 231 a and a plurality of micro-structures 231 b. The micro-structures 231 a are protruded from the reference surface R in a direction away from the lighting device 220 and the micro-structures 231 b is depressed from the reference surface R in a direction towards the lighting device 220. The micro-structures 231 a and 231 b both have a pyramid shape, and both are separated from each other by a distance ranging between 0 and 500 µm. As indicated in FIG. 8, the micro-structures 231a and the micro-structures 231b are interlaced with each other. However, anyone who is skilled in the technology of the invention will be able to make modification according to the application of the terminal products, and the arrangement is not limited to the interlacing arrangement.

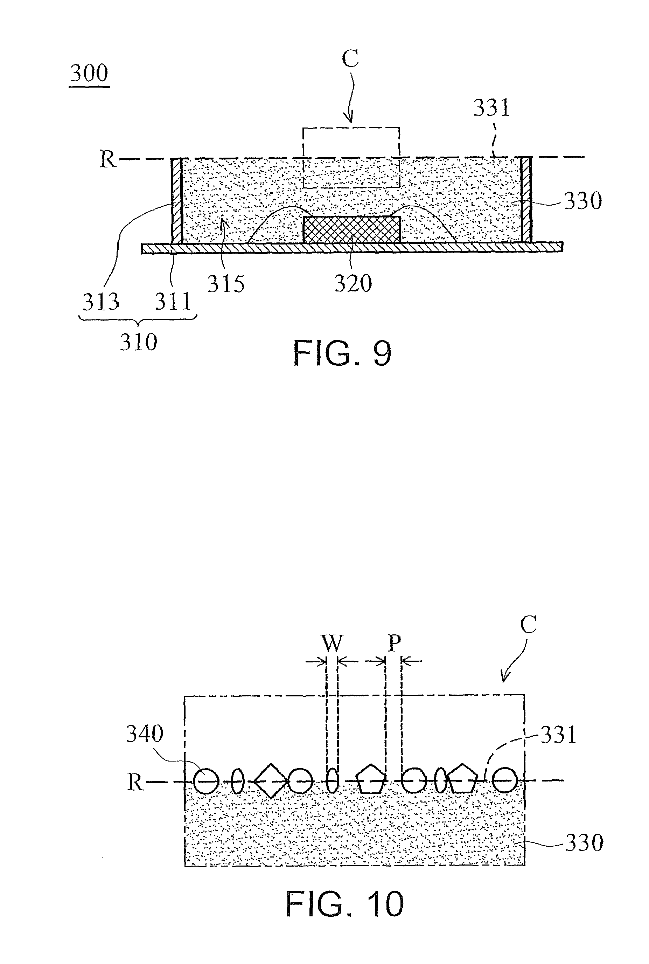

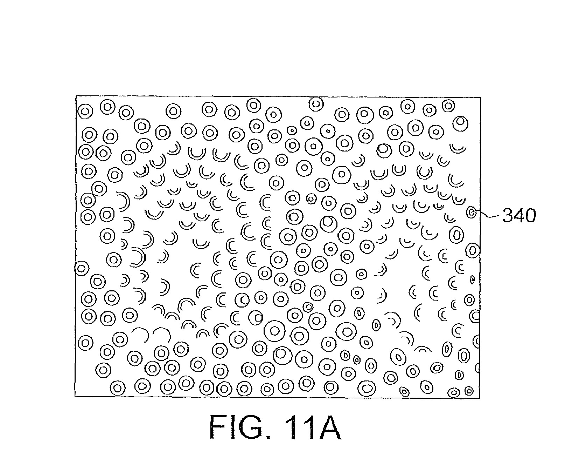

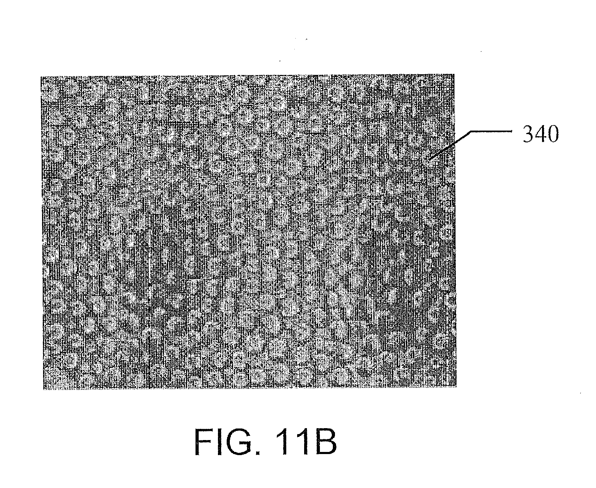

Referring to FIGS. 9 to 11B, wherein FIG. 9 shows a cross-sectional view of an LED package 300 according to another embodiment of the invention, FIG. 10 shows an enlargement view of an area C of FIG. 9, FIG. 11A shows a top view of an area C of FIG. 9, and FIG. 11B shows an appearance of the micro-structures of FIG. 11A. The top view is an actual photo taken by a CCD image sensor of an optical microscopy. In the present embodiment, corresponding components similar or identical to above embodiments retain the same numeric designations, and the similarities of corresponding components that have been disclosed are not repeated. The outer surface of 331 of the sealing material 330 of the LED package 300 comprises a plurality of micro-structures 340, wherein each of the micro-structures 340 is a micro-particle protruded from a reference surface R. The refraction index of the micro-structures (micro-particles) 340 is approximately equal to that of the sealing material 330, the arrangement interval P ranges from 0∼500 µm, the diameter W of each micro-particle ranges from 10∼500 µm, and the roughness (Ra) is about 30 µm. When the interval P 0 µm, the arrangement has the largest density. In the present embodiment, the micro-structures (micro-particles) 340 are formed in a circular shape, an elliptical shape or polygonal or any combination of these shapes, and a part of volume of the micro-structures is located below the reference surface R. The ratio of the volume of the micro particle protruded above the reference surface R to the volume of the entire micro particle is about 33-66%.

A method for manufacturing the micro-structures (micro-particles) 340 is disclosed below. Firstly, a plurality of micro-structures (micro-particles) 340 whose refraction index and specific gravity are equivalent to that of the sealing material 330 is manufactured. Next, the micro-structures (micro-particles) 340 are placed on a sealing material 330 in a non-cured state, so that micro-particles 340 can be embedded into the sealing material 330. Then, the sealing material 330 is dried by baking to finish the molding of the micro-structures (micro-particles) 340. In the present embodiment, the micro-structures (micro-particles) 340 are formed by glass, but the invention is not limited thereto.

In the above process, after the sealing material 330 is dried, if a portion of the micro-structures (micro-particles) 340 is removed from the sealing material 330, a plurality of depressed micro-structures (not illustrated) will be formed on the outer surface 331 of the sealing material 330.

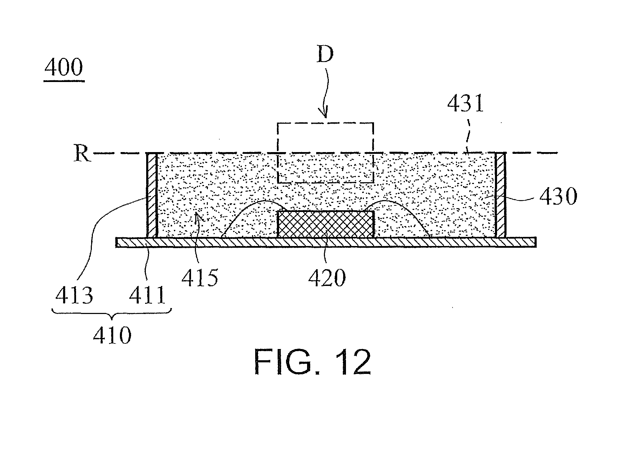

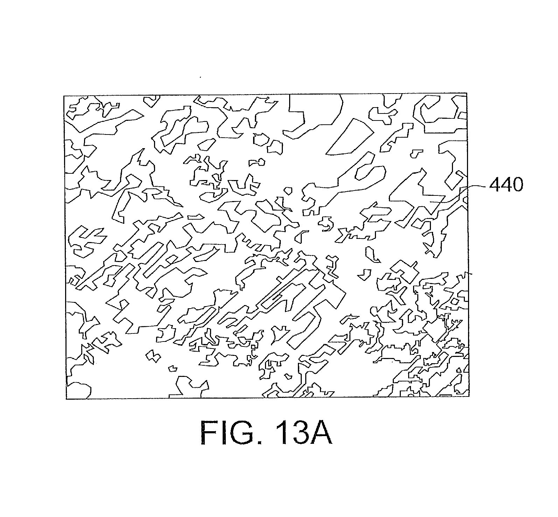

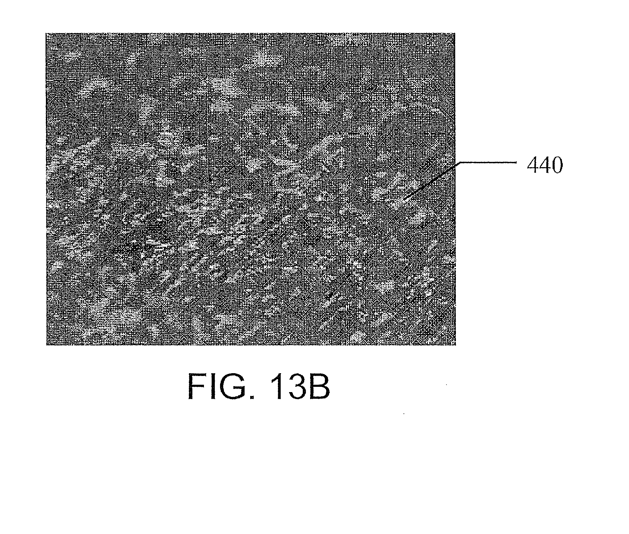

Referring to FIGS. 12 to 13B, wherein FIG. 12 shows a cross-sectional view of an LED package 400 according to another embodiment of the invention, and FIG. 13A shows a top view of an area D of FIG. 12, and FIG. 13B shows an appearance of the micro-structures of FIG. 13A. The top view is an actual photo taken by a CCD image sensor of an optical microscopy. In the present embodiment, corresponding components similar or identical to above embodiments retain the same numeric designations, and the similarities of corresponding components that have been disclosed already are not repeated. The outer surface 431 of the sealing material 430 of the LED package 400 comprises a plurality of micro-structures 440. As indicated in FIG. 13A, the micro-structures 440 are formed by a plurality of micro-particles irregularly protruded from the outer surface 431 of the sealing material 430, wherein the roughness (Ra) of the micro-particles is about 100 µm.

A method for manufacturing the micro-structures 440 is disclosed below. Firstly, a spray gun (not illustrated) is used to spray the micro-structures (micro-particles) 440 on the outer surface 431 of the sealing material 430. Next, the micro-structures (micro-particles) 440 are dried by baking to finish the molding of the micro-structures 440.

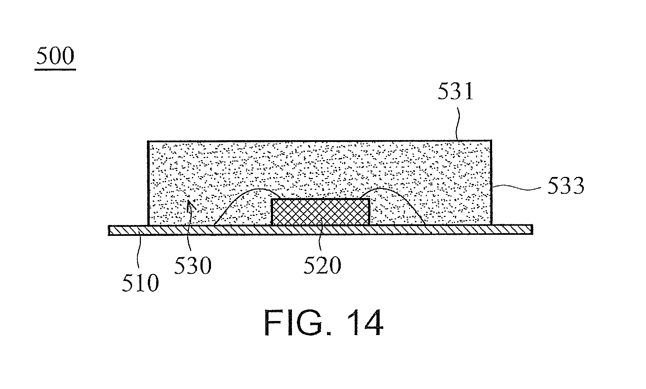

Referring to FIG. 14, a cross-sectional view of an LED package 500 according to another embodiment of the invention is shown. In the present embodiment, the sealing material 530 is disposed on the lighting device 520 and directly cured on the base 510. The outer surface 531 of the sealing material 530 located away from the base 510 and the outer surface 533 between the outer surface 531 and the base 510 both have a plurality of micro-structures disclosed in the above embodiments. However, anyone who is skilled in the technology of the invention may combine the micro-structures of the above embodiments to be used in different packages.

The LED package of the invention reduces the likelihood of total reflection of the light on the outer surface of the sealing material, hence increasing extraction efficiency.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to cover all such modifications and similar arrangements.

## Claims

1. An LED package, comprising:
a base;
a lighting device, disposed on the base; and
a sealing material, disposed on the lighting device and comprising a plurality of micro-structures, wherein the micro-structures are composed of a plurality of protruded micro-structures, a plurality of depressed micro-structures or any combination thereof, and
wherein at least a partial of a light emitted from the lighting element is transmitted to an ambient through the micro-structures.

2. The LED package as claimed in claim 1, wherein the protruded micro-structures and the depressed micro-structures have a pyramid shape.

3. The LED package as claimed in claim 1, wherein each of the protruded micro-structures is a micro particle whose refraction index is equal to the refraction index of the sealing material.

4. The LED package as claimed in claim 3, wherein the micro particles are spaced apart from each other by a distance ranging between 0 and 500 micrometers (µm).

5. The LED package as claimed in claim 3, wherein the diameter of each of the micro particles rages between 10 and 500 µm.

6. The LED package as claimed in claim 3, wherein the protruded micro-structures are the micro particles, and the Ra roughness of the surface of the sealing material is about 30 µm.

7. The LED package as claimed in claim 3, wherein the micro particles are formed in a circular shape, an elliptical shape or polygonal or any combination of these shapes.

8. The LED package as claimed in claim 1, wherein the depressed micro-structures are depressed from a reference surface in a direction towards the lighting device, and the protruded micro-structures are protruded from the reference surface in a direction away from the lighting device.

9. The LED package as claimed in claim 8, wherein the reference surface is a flat plane.

10. The LED package as claimed in claim 9, wherein the base comprises an accommodating space defined in a side wall, and the lighting device is disposed in the accommodating space, the sealing material is filled in the accommodating space to cover the lighting device, and the reference surface is aligned with the outer rim of the side wall.

11. The LED package as claimed in claim 8, wherein each of the protruded micro-structures is a micro particle whose refraction index is equal to the refraction index of the sealing material, and a portion of each of the micro particles is located below the reference surface.

12. The LED package as claimed in claim 11, wherein the ratio of the volume of the protruded portion of the micro particle above the reference surface to the volume of the entire micro particle is about 33-66%

13. The LED package as claimed in claim 3, wherein the micro particles are spaced apart from each other by a distance ranging between 0 and 500 µm.
